# EUROPEAN PATENT SPECIFICATION

(11) **EP 0 277 885 B1**
(45) Date of publication and mention of the grant of the patent: **22.12.1993**
(21) Application number: 88400268.4
(22) Date of filing: 05.02.1988
(51) Int. Cl.: H01L 39/24

(54) **Process for preparing a superconducting thin film**
Verfahren zum Herstellen einer supraleitenden Dünnschicht
Procédé de préparation d'une couche mince supraconductrice

(30) Priority: 05.02.1987 JP 25222/87; 17.02.1987 JP 33774/87
(43) Date of publication of application: 10.08.1988
(73) Proprietor: SUMITOMO ELECTRIC INDUSTRIES LIMITED, Osaka-shi, Osaka 541 (JP)
(72) Inventor: Itozaki, Hideo c/o Itami Works of Sumitomo, Itami-shi Hyogo (JP); Fujita, Nobuhiko c/o Itami Works of Sumitomo, Itami-shi Hyogo (JP); Okura, Kengo c/o Osaka Works of Sumitomo, Konohana-ki Osaka (JP)
(74) Representative: Hirsch, Marc-Roger

(56) References cited:
- EP-A- 0 280 273
- EP-A- 0 284 489
- DE-A- 3 715 623
- FR-A- 2 469 005
- PHYSICAL REVIEW LETTERS, vol. 58, no. 4, 26th January 1987, pages 405-407, The American Physical Society; C.W. CHU et al.: "Evidence for superconductivity above 40 K in the La-Ba-Cu-O compound system"
- PHYSICAL REVIEW LETTERS, vol. 58, no. 4, 26th January 1987, pages 408-410, The American Physical Society; R.J. CAVA et al.: "Bulk superconductivity at 36 K in La1.8Sr0.2CuO4
- JAPANESE JOURNAL OF APPLIED PHYSICS, vol. 26, no.4, April 1987, pages L410-L412; S. NAGATA et al.: "High Tc thin films of (La1-xMx)yCuO4-delta (M=Sr, Ba, Ca) prepared by sputtering"

## Description

### Background of the Invention

### Field of the invention

The present invention relates to a process for preparing a thin film of superconductor. More particularly, it relates to a process for depositing on a substrate a superconducting thin film of a compound oxide having higher transition temperature of superconductivity which can be used for Josephson Junctions devices or the like.

More particularly, the present invention relates to a process for depositing a superconducting thin film of K₂NiF₄-type oxides such as [La, Ba]₂CuO₄, [La, Sr]₂CuO or the like.

### Description of the related art

The superconductivity is a phenomenon in which the electrical resistance become zero and hence can be utilized to realize a variety of devices and apparatus which are requested to reduce consumption of electrical energy and several ideas of its applications which utilize the phenomenon of superconductivity have been proposed. However, their actual usage have been restricted because the phenomenon of superconductivity can be observed only at very low cryogenic temperatures. Among known superconducting materials, a group of materials having so-called A-15 structure show rather higher Tc (critical temperature of superconductivity) than others, but even the top record of Tc in the case of Nb₃Ge which showed the highest Tc could not exceed 23.2 K at most.

This means that liquidized helium (boiling point of 4.2 K) is only one cryogen which can realize such very low temperature of Tc. However, helium is not only a limited costly resource but also require a large-scaled system for liquefaction. Therefore, it had been desired for another superconducting materials having higher Tc. But no material which exceeded the abovementioned Tc had been found for all studies for the past ten years.

Possibility of existence of a new type of superconducting materials having much higher Tc was revealed by Bednorz and Muller who discovered a new oxide type superconductor in 1986 ( Z. Phys. B64 (1986) 189 )
This new oxide type superconducting material is [La, Ba]₂CuO₄ or [La, Sr]₂CuO₄ which are called as the K₂NiF₄-type oxide having a crystal structure similar to Perovskite-type superconducting oxides which have been known (for example, U.S.Patent No. 3,932,315). The K₂NiF₄-type oxides show such higher Tc as 30 K which are extremely higher than the known superconducting materials and hence it becomes possible to use liquidized hydrogen (b.p. = 20.4 K) or liquidized neon (b.p. = 27.3 K) as a cryogen which bring them to exhibit the superconductivity. Particularly, hydrogen is an inexhaustable resource except for danger of explosion.

Conventional methods for producing superconducting compounds or metal alloys may be classified into two categories of (a) the powder sintering technique in which starting materials are blended into a mixture which is then sintered, and (b) the vapour deposition technique in which an alloy or a compound is vapourized in gas phase and deposited or grown on a substrate.

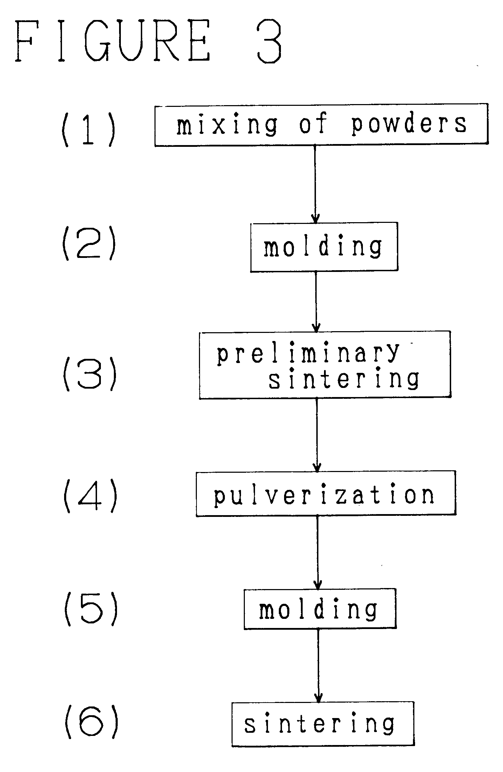

Figure 3 shows a series of operations in the typical powder sintering process abovementioned which includes the following steps:
(1) uniformly mixing powders having a particle size of several µm such as BaCO₃, La₂CO₃ or SrCO₃, and CuO,
(2) molding the powders in a mold,
(3) performing preliminary sintering of the molded article at 900 °C for 12 hours,
(4) removing the sintered article out of the mold and then pulverizing the same again,
(5) press-molding the pulverized power, and
(6) sintering (reaction-sintering) the press-molded article at 1,100 °C for 2 hours.

The vapour deposition technique has been used for producing a thin film of superconducting material such as Nb₃Ge and BaPb₁₋ₓBiₓO₃. In case of a thin film of Nb₃Ge, particles of Nb and Ge are sputtered out of several targets each consisting of Nb and Ge respectively and are deposited onto a substrate to form a film composed of Nb₃Ge. Japanese patent laid-open No. 56-109,824 discloses a process for producing a thin film of BaPb₁₋ₓBiₓO₃. by means of sputtering technique.
However, the above mentioned new type superconducting materials of K₂NiF₄-type oxides which was just born have been studied and developed only in a form of sintered bodies or as a bulk produced from powders which have been press-molded previously. In other words, heretofore, no study of film-deposition technique have been tried on these new type superconductors. Therefore, the resultant superconducting bodies must have a form of a bulk which is difficult to be utilized in the form of a thin film which is required in the field of electrical devices or elements.
Therefore, an object of the present invention is to provide a process which can change the K₂NiF₄-type superconducting oxides into a thin film form.

### Summary of the Invention

A subject of the present invention resides in a process for preparing a superconducting thin film composed of a compound oxide of La and Cu and Sr, by sputtering technique, characterised in that it comprises the use of a target composed of a powder mixture of oxides, carbonates, nitrates, and/or sulfates of La, Cu and Sr, and in that the substrate on which the thin film is deposited is heated at a temperature between 200 °C and 1 200 °C during the sputtering.

The subject of the present invention also resides in a process for preparing a superconducting thin film composed of a compound oxide of La and Cu and Ba, by sputtering technique, characterised in that it comprises the use of a target composed of a powder mixture of oxides, carbonates, nitrates, and/or sulfates of La, Cu and Ba, and in that the substrate on which the thin film is deposited is heated at a temperature between 900 °C and 1 200 °C during the sputtering.

The proportions or atom ratios of La, an element M and Cu in the compounds for the target are preferably adjusted in such manner that the resulting superconducting thin film presents a composition corresponding to the formula (La₁₋ₓ, Mₓ)₂CuO_{4-y}, where 0 < x < 1, 0 <= y < 4, and M is Ba or Sr.

If said element M is Ba, the value of x in the composition is preferably selected in the range of 0,025 to 0,125. If said element M is Sr, the value of x in the composition is preferably selected in the range of 0,09 to 0,25.

According to the invention, the superconducting thin film may include the crystal structure of K₂NiF₄-types oxides. Preferably, the powder mixture is composed of La₂CO₃ and CuO, and one of BaCO₃ or SrCO₃.

According to an embodiment of the invention, the powder mixture is composed of 70 to 95% by weight of La₂CO₃, 1 to 20% by weight of BaCO₃ or SrCO₃, and 1 to 30% by weight of CuO.

According to the invention, the deposited thin film may be heat treated at a temperature between 600 and 1200°C after the sputtering.

According to another feature of the invention, the powder mixture is sintered into a form of a sintered body which is used as the target.

Furthermore, the powder mixture may be sintered in a powder hot-press or in a hot isostatic press (HIP).

The invention also provides that the sputtering may be operated under the presence of oxygen gas.

In this case, the partial pressure of oxygen gas is preferably adjusted to a range comprised between 1,33.10⁻⁴ and 6,67 Pa (10⁻⁶ and 5x10⁻² Torr).

Finally, according to an embodiment of the invention, a voltage of 10 to 500 V is impressed onto said substrate during the sputtering.

The invention also concerns a superconducting thin film presenting a composition corresponding to the formula (La₁₋ₓ, Mₓ)₂CuO_{4-y}, where 0 < x < 1, 0 <= y < 4, and M is Ba or Sr, obtained with the process described above.

The substrate may be selected from any materials which are known and used in the field of the sputtering technique, such as a single crystal of magnesia, strontium titanate, beryllia, alumina, silicon, yttrium stabilized zirconia (YSZ) or the like.

Now, an apparatus which can be used to realize the abovementioned process according to the present invention will be described with reference to attached drawings which are not limitative of the present invention.

### Brief description of the drawings

Figure 1 illustrates an example of an sputtering machine which is used to carry out the process of the present invention.
Figure 2 shows an illustrative cross section of an embodiment of a mold used for powder molding,
Figure 3 shows an example of manufacturing steps used in the powder molding technique,
Figure 4 is an illustration of a test sample for determining the temperature dependency of the superconducting thin film produced according to the present invention.
Figure 5 is a graph showing the temperature dependency of resistance of [La, Ba]₂CuO₄ thin films produced according to Example 1 of the process of the present invention and according to comparative example respectively.
Figure 6 is a graph showing the temperature dependency of resistance of [La, Sr]₂CuO₄ thin films produced according to Example 2 of the process of the present invention and according to comparative example respectively.

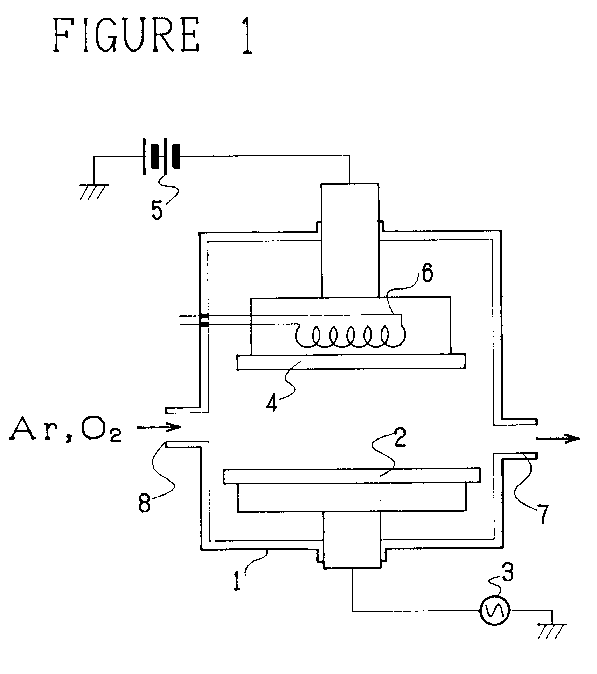

An apparatus illustrated in Figure 1 shows a sputtering machine including a material target 2 enclosed in a vacuum chamber or bell jar 1 and a substrate 4 on which the thin film is deposited and being faced to the target 2. A vacuum pump (not shown) communicated through a port 7 with the interior of the chamber 1 functions to create vacuum therein. The target is impressed with high-frequency from a high-frequency power source 3.

Bias voltage is impressed on the substrate 4 from a source of high-voltage 5. The substrate 4 is heated by a heater 6 so that the temperature of the substrate is adjustable. The bell jar 1 has a gas inlet 8 for introducing argon gas and oxygen gas.

In operation, the target 2 is sputtered with Ar ions under the presence of oxygen whose content or proportion is adjusted so that additional oxygen is supplied to a thin film which will be deposited on the substrate 4 to produce a desired oxide.

### Description of the Preferred Embodiments

In a preferable embodiment according to the present invention, said mixture is sintered into a form of a sintered body. Namely, the target used in sputtering is made of a sintered body which is produced by sintering a powder mixture of abovementioned compounds each containing at least one of La, said element M and Cu.

In this case, it is preferable to use a target of a sintered body which is made from such a mixture of the compounds that proportions or atom ratios of La, said element M and Cu in the mixture are adjusted in such manner that the resulting thin film of compound oxide of La, said element M and Cu has a composition of

[La₁₋ₓ, Mₓ]₂CuO_{4-y}

in which, M is Ba or Sr, 0 < x < 1 and 0 ≦ y < 4.

When Ba is used as the element M, the value of the x in the abovementioned composition is preferably selected in the range of 0.025 ≦ x ≦ 0.12, while, when Sr is used as the element M, the value of the x in the abovementioned composition is preferably selected in the range of 0.09 ≦ x ≦ 0.25.

The compounds may be selected from a group comprising oxides of La, said element M and Cu, carbonates of the same, nitrate of the same or sulfates of the same.

In an embodiment of the present invention, said mixture of compounds may be a powder mixture of La₂CO₃, BaCO₃ or SrCO₃, and CuO. In this case, said powder mixture is preferably a powder mixture composed of 70 to 95 % by weight of La₂CO₃, 1 to 20 % by weight of BaCO₃ or SrCO₃, and 1 to 30 % by weight of CuO.

It is preferable that the operation of sintering is carried out in a powder hot-press or in a hot isostatic press (HIP).

The sputtering is preferably operated under the presence of oxygen gas. The partial pressure of oxygen gas is preferably adjusted to a range between 1,33.10⁻⁴ and 6,67 Pa (10⁻⁶ and 10⁻² Torr). It is also preferable that the substrate on which the thin film is deposited is heated at a temperature between 200 and 1,200°C during sputtering operation, in the case of the compound oxide of La, Cu and Sr, and is heated at a temperature between 900 and 1,200°C during sputtering operation, in the case of the compound oxide of La, Cu and Ba.

It is also preferable that a voltage of 10 to 1 500 V is impressed onto said substrate during sputtering operation. Another preferable feature of the present invention resides in that, after the sputtering operation complete, the deposited thin film is heat-treated at a temperature between 600 and 1,200°C.

The structure of the resulting thin film can be approved to be a crystalline film having K₂NiF₄-type layered perovskite structure by electron probe microanalysis (EPMA) or X-ray diffraction.

According to a preferred embodiment of the present invention, the process for preparing a superconducting thin film composed of a compound oxide of La, one element M selected from a group of Ba or Sr and Cu by sputtering technique is characterized in that a target of a sintered body which is made from such a mixture of the compounds that proportions or atom ratios of La, said element M and Cu in the mixture are adjusted in such manner that the resulting thin film of compound oxide of La, said element M and Cu has a composition of

[Lal-x, Mx]2CuO4-y

in which, M is Ba or Sr 0 < x < 1 and 0 ≦ y < 4, and in that after the sputtering complete, the deposited thin film is heat-treated at a temperature between 600 and 1,200°C in air.

According to another preferred embodiment of the present invention, the process for preparing a superconducting thin film composed of a compound oxide of La, one element M selected from a group of Ba or Sr and Cu by sputtering technique, is characterized in that a target of a sintered body which is made from such a mixture of the compounds that proportions or atom ratios of La, said element M and Cu in the mixture are adjusted in such manner that the resulting thin film of compound oxide of La, said element M and Cu has a composition of

[Lal-x, Mx]2CUO4-y

in which, M is Ba or Sr, 0 < x < 1 and 0 ≦ y < 4, in that a substrate on which the thin film is deposited is heated at a temperature between 200 and 1,200°C during sputtering operation, in the case of the compound oxide of La, Cu and Sr, and is heated at a temperature between 900 and 1,200°C during sputtering operation, in the case of the compound oxide of La, Cu and Ba, and in that, after the sputtering complete, the deposited thin film is heat-treated at a temperature between 600 and 1,200°C in air.

In operation, during the sputtering operation, argon gas contained in the vacuum chamber is ionized into Ar+ and is accelerated so that the Ar⁺ strikes against the target composed of objective material to be deposited into a film, resulting in that particles sputtered out of the target are deposited on the substrate in a form of a thin film. When the target is made of a compound oxide made from La₂O₃, SrCO₃, and CuO or the like, particles of each of the oxides are sputtered. If, on this stage of sputtering process, oxygen gas is introduced into the vacuum chamber, the thin film of [La₁₋ₓ, Baₓ]₂CuO_{4-y} or [La₁₋ₓ, Srₓ]₂CuO_{4-y} which is the most stable compound is deposited on the substrate.

It is affirmed that the composition of the thin film deposited on the substrate depend on the composition of material of the target. The present invention is based on such finding of the present inventors. Thus, if the atom ratios of La, said element M, Cu and oxygen in the target are adjusted in such manner that the resulting thin film of compound oxide of La, said element M and Cu has a composition of [La₁₋ₓ, Mₓ]₂CuO_{4-y}, ( wherein M is Ba or Sr, 0 < x < 1 and O ≦ y < 4 ), the thin film of superconductors having high-Tc superconducting can be produced. In other words, the thin film of superconductors having high-Tc superconducting compound and having K₂NiF₄-type layered perovskite structure can be obtained by controlling the proportions in the mixture of the target.

In a preferred embodiment, the sputtering is performed by using a target which is a sintered body which is produced by sintering material powders of oxides, carbonates, nitrides or sulfates each containing at least one of La, Ba (or Sr) and Cu which are constituent elements of the resultant superconducting film having the K₂NiF₄-type oxide.

The K₂NiF₄-type compound oxide can be changed into a film, since these oxides, carbonates, nitride and sulfates are relatively stable.

According to a preferred embodiment, the sintered body is made from powders of La₂O₃, BaCO₃ (or SrCO₃) and CuO having such proportions as 70 to 95 % by weight of La₂CO₃, 1 to 20 % by weight of BaCO₃ or SrCO₃, and 1 to 30 % by weight of CuO.

Now, we will describe how to control proportions of components in the thin film.

Table 1. shows melting points of the abovementioned powder:

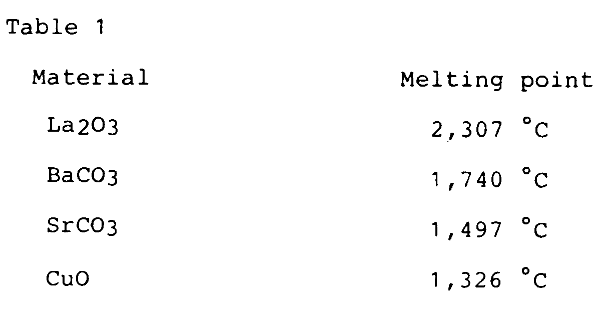

It is apparent from Table 1 that La₂O₃ have a higher melting point than the others and hence is considered to be evaporated at lower speed of evaporation than others during the sputtering. This means that the desired proportions of elements in the thin film cannot be obtained if the sintered body has not proper proportions of elements. According to the present invention, the target consisting of a molded and sintered body contains a excess amount of La₂O₃ which is larger than the desired stoichiometrical proportion in the thin film. Namely, according to a preferred embodiment, the target is composed of a sintered body produced from a mixture of 70 to 90 % by weight of La₂O₃, 1 to 20 % by weight of BaCO₃ (or SrCO₃) and 1 to 30 % by weight of CuO.

When the target is a mixture of La₂CO₃, BaCO₃ and CuO is used, a thin film of [La₁₋ₓ, Baₓ]₂CuO_{4-y} is obtained, while when the target is a mixture of La₂CO₃, SrCO₃, and CuO is used, a thin film of [La₁₋ₓ, Srₓ]₂CuO_{4-y} is obtained. The higher critical temperature is expected in a range of 0.025 ≦ x ≦ 0.125 for [La₁₋ₓ, Baₓ]₂CuO_{4-y} and in a range of 0.09 ≦ x ≦ 0.25 for [La₁₋ₓ, Srₓ]₂CuO_{4-y} respectively.

The composition of the thin film is not influenced much by the existence of the abovementioned non-reacted portions in the target but is rather influenced greatly by the proportion of powders in the mixture. In the industrial scale, the powder sintering is preferably carried out by a hot pressing for powder, a hot isostatic pressing for powder or the like.

According to another aspect of the present invention, the sputtering is preferably operated in an atmosphere of oxygen gas under the presence of argon gas. The partial pressure of the oxygen gas is preferably adjusted to a range between 1,33.10⁻⁴ and 6,67 Pa (10⁻⁶ and 5x10⁻² Torr), more preferably between 1,33.10⁻⁴ and 1,33 Pa (10⁻⁶ and 10⁻² Torr).

According to still another aspect of the present invention, a substrate on which the thin film is deposited is preferably heated at a temperature between 200 and 1,200°C during sputtering operation, in the case of the compound oxide of La, Cu and Sr, and is heated at a temperature between 900 and 1,200°C during sputtering operation, in the case of the compound oxide of La, Cu and Ba. Still more, a voltage of less than 500 V is preferably impressed onto the substrate during sputtering operation to drive ionized oxygen towards the substrate.

According to still another aspect of the present invention, the deposited thin film is preferably heattreated at a temperature between 600 and 1 200°C, after the sputtering complete.

In case of K2NiF4-type oxide according to the present invention, it is important that oxygen atoms are contained orderly among the other constituent atoms. Therefore, according to a preferred embodiment, the partial pressure of oxygen is adjusted between 1,33.10⁻⁴ and 6,67 Pa (10⁻⁶ and 5x10⁻² Torr), more preferably between 1,33.10⁻⁴ and 1,33 Pa (10⁻⁶ and 10⁻² Torr) during the sputtering in order to rationalize the amount of oxygen in the resultant superconducting thin film. If the partial pressure is lower than 1,33.10⁻⁴ Pa (10-6 Torr), no effect of addition of oxygen is obtained because substantially no oxygen exist in the atmosphere. To the contrary, if the partial pressure of oxygen exceed 6,67 Pa (5x10⁻² Torr), sputtering cannot be practiced since the pressure of vacuum become too high. Therefore, the partial pressure of oxygen must be within a range between 1,33.10⁻⁴ Pa and 6,67 Pa (10⁻⁶ and 5 x 10⁻² Torr), more preferably 1,33.10⁻⁴ Pa and 1,33 Pa (10⁻⁶ Torr and 10⁻² Torr). The sputtering may be high-frequency sputtering or DC sputtering, but high-frequency sputtering is preferable. In special case, the thin film may be produced by ion-plating technique.

In case of the high-frequency sputtering, the power of high-frequency imposed vary according to sputtering machines used but is preferably lower than 5,000 W. In fact, if the power exceeds 5,000 W, excess energy is given to ions in vacuum, which result in a trouble of increase of impurities produced out of walls in the chamber.

It is possible also that the substrate is biased at a voltage between 0 V and 500 V, more preferably between 10 V and 500 V, so that ionized oxygen are accelerated towards the substrate. Higher voltages which exceed 500 V should not be used because abnormal discharge due to DC voltage will be produced and because ions are struck into the thin film exceedingly, resulting in a great number of defects will be produced in the film and hence the film will be deteriorated.

Still more, when the temperature of the substrate is not higher than 100 °C, the thin film becomes amorphous which do not exhibit the superconductivity. To the contrary, if the substrate is heated at a higher temperature than 1,200 °C, it is difficult to adjust the proportions of elements in the film. Therefore, the temperature of the substrate is preferably within a range of from 200°C to 1,200°C in air in the case of the compound oxide of La, Cu and Sr, and within a range from 900°C to 1,200°C during sputtering operation, in the case of the compound oxide of La, Cu and Ba.

It is effective to heat the resulting superconducting thin film obtained by the abovementioned film forming process at a temperature between 600 and 1,200°C in air in order to improve the superconductivity.

The resulting superconducting thin film obtained according to the abovementioned process shows far higher superconducting critical temperature than existing superconducting films and hence superconducting transition can be realized without using liquidized helium.

Now, the process according to the present invention will be described with reference to illustrative Examples, but the scope of the present invention should not be limited thereto.

### Example 1 - Preparation of [La, Sr]2CuO4 thin film -

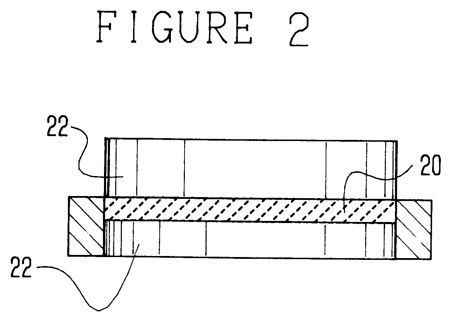

Powders of La2O3, SrCO3 and CuO are mixed uniformly in the proportion of 1.66 : 0.34 : 1 to prepare a target. Then, the powder mixture is subjected to a preliminary sintering at 900°C for 12 hours in a mold shown in Figure 2 in which 20 denotes powders for a target and 22 denotes the mold.

The resulting molded article removed out of the mold is very fragile and is then pulverized again. The resulting pulverized powder is subjected to the final sintering at 1,100 °C for 2 hours.

A sintered body obtained by the procedure abovementioned as a target is set in a sputtering machine shown in Figure 1. Sputtering is performed under such conditions that a surface of the substrate is maintained at a temperature of 200 °C and a high-frequency voltage of 1 KV is impressed to the substrate.

The resulting thin film is affirmed to be a crystalline film having K₂NiF₄-type layered perovskite structure by electron probe microanalysis (EPMA).

After the thin film is annealed at 900 °C, the transition temperature or the critical temperature is measured to found a higher transition temperature than 30 K.

It is impossible to obtain thin film consisting of a compound of [La₁₋ₓ, Srₓ]₂CuO_{4-y} and having higher transition temperatures when the value of x does not fall within the range of 0.09 ≦ x ≦ 0.25.

### Example 2 - Preparation of [La, Ba]₂CuO₄ thin film -

[La, Ba]₂CuO₄ thin film is produced in a high-frequency sputtering machine illustrated in Figure 1.

A material target is a sintered body made from a powder mixture of La₂O₃, BaCO₃ and CuO, while the substrate 4 is of a silicon crystal. The film is produced in the following conditions:

| | |
|---|---|
| Partial pressure of Ar as sputtering gas | 0,13 Pa (10⁻³ Torr) |
| Partial pressure of oxygen | 0,013 Pa (10⁻⁴ Torr) |
| Temperature of the substrate | 900°C |
| High-frequency power impressed to the target | 500W |
| Substrate bias voltage | 50 V |

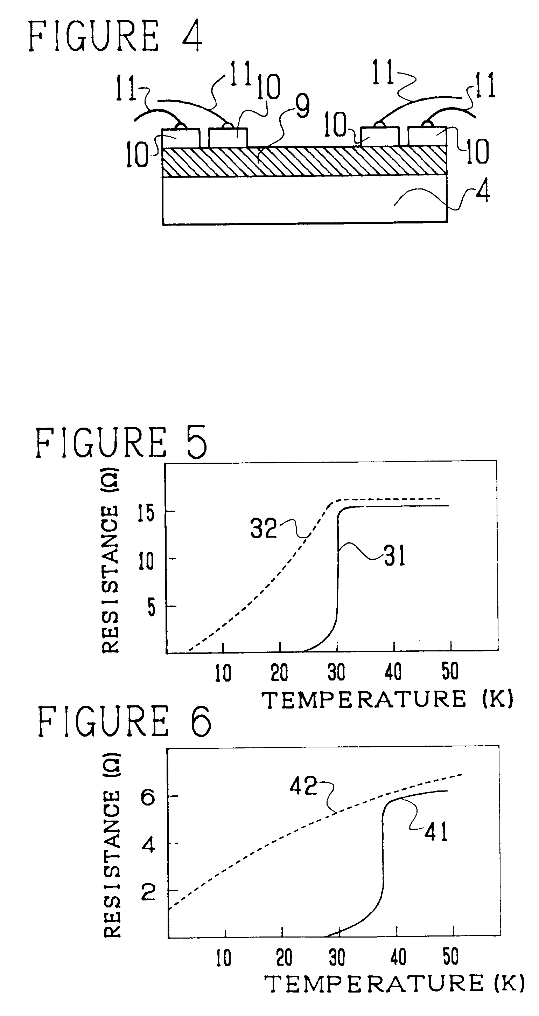

A thickness of about 1 µm is obtained at a filmforming speed of 10 A/sec. As a comparative example, the same procedure is repeated except that oxygen is not supplied. From the resulting each substrate having a thin film, a sample shown in Figure 4 is prepared to determine the resistance of the thin film. The sample for resistance measurement shown in Figure 4 comprises the substrate 4, a thin film 9 of [La, Ba]₂CuO₄ deposited on the substrate, and two pairs of electrodes 10 made of aluminum which is vacuum-deposited on a surface of the thin film 9. Two pairs of lead wires 11 are soldered to the aluminum electrodes 10 respectively.

Figure 5 shows the temperature dependency of resistance of the thin films measured on Example 1 and its comparative example. In Figure 5, a curve expressed by a solid line having a reference number 31 shows the temperature dependency of the resistance of the thin film which is produced in a bell jar containing oxygen whose partial pressure is 0,013 Pa (10⁻⁴ Torr), while another curve shown by a phantom line having a reference number 32 shows that of another thin film which is produced in the bell jar into which oxygen is not fed.

It is apparent from the curve of resistance 31, the thin film produced according to the process of the present invention shows the onset temperature when the phenomenon of superconductivity start is about 30 K and complete superconductivity is observed under 25 K, while the curve of resistance 32 shows the zero-resistance only below several K and has a rather gentle slope although the resistance start to drop from nearly same temperature as the above case. Comparison between these two curves of resistance reveals that introduction of oxygen gas into the bell jar during the film is deposited permit to control or adjust the oxygen contents in the thin film properly to obtain a superconductive thin film having a desired composition.

### Example 3

### - preparation of a thin film of [La, Sr]₂CuO₄ -

The same procedure as the Example 2 for [La, Ba]₂CuO₄ is repeated. As material target, a sintered body produced from a powder mixture of La₂O₃, SrCO₃ and CuO is used. Films are deposited by using two different targets each consisting of a sintered body produced from a powder mixture containing 20 % and 60 % by weight of CuO respectively.

The film is deposited under the following conditions:

| | |
|---|---|
| Partial pressure of Ar as sputtering gas | 0,13 Pa (10⁻³ Torr) |
| Partial pressure of oxygen | 0,013 Pa (10⁻⁴ Torr) |
| Temperature of the substrate | 900°C |
| High-frequency power impressed to the target | 500W |
| Substrate bias voltage | 50 v |

Figure 6 shows the temperature dependency of resistance of the resulting thin films, wherein a curve expressed by a solid line having a reference number 41 illustrates the curve of resistance of a thin film produced by the first target containing 20 % by weight of CuO, while another curve expressed by a phantom line having a reference number 42 illustrates that of another thin film produced by second target containing 60 % by weight of CuO.

It is apparent from the curve 42, the thin film produced from the second target containing 60 % by weight of CuO does not show superconductivity, while the thin film produced from the first target containing 20 % by weight of CuO according to the present invention shows the onset temperature of about 38 K and complote superconductivity is observed below 27 K. Thus, the film corresponding to the curve of resistance 41 shows improved properties as a superconductor

## Claims

1. A process for preparing a superconducting thin film composed of a compound oxide of La and Cu and Sr, by sputtering technique, characterised in that it comprises the use of a target composed of a powder mixture of oxides, carbonates, nitrates, and/or sulfates of La, Cu and Sr, and in that the substrate on which the thin film is deposited is heated at a temperature between 200 °C and 1 200 °C during the sputtering.

2. A process for preparing a superconducting thin film composed of a compound oxide of La and Cu and Ba, by sputtering technique, characterised in that it comprises the use of a target composed of a powder mixture of oxides, carbonates, nitrates, and/or sulfates of La, Cu and Ba, and in that the substrate on which the thin film is deposited is heated at a temperature between 900 °C and 1 200 °C during the sputtering.

3. Process according to claim 1 or 2, characterised in that the superconducting thin film presents a composition corresponding to the formula (La₁₋ₓ, Mₓ)₂CuO_{4-y}, where 0 < x < 1, 0 ≦ y < 4, and M is Ba or Sr.

4. Process according to claim 3, characterised in that said element M is Ba, and the value of x in the composition is selected in the range of 0,025 to 0,125.

5. Process according to claim 3, characterised in that said element M is Sr, and the value of x in the composition is selected in the range of 0,09 to 0,25.

6. Process according to one of the claims 1 to 5, characterised in that said superconducting thin film includes the crystal structure of K₂NiF₄-types oxides.

7. Process according to one of the claims 1 to 6, characterised in that said powder mixture is composed of La₂CO₃ and CuO and one of BaCO₃ or SrCO₃.

8. Process according to one of the claims 1 to 7, characterised in that said powder mixture is composed of 70 to 95% by weight of La₂CO₃, 1 to 20% by weight of BaCO₃ or SrCO₃, and 1 to 30% by weight of CuO.

9. Process according to one of the claims 1 to 8, characterised in that the deposited thin film is heat treated at a temperature between 600 and 1200 °C after the sputtering.

10. Process according to one of the claims 1 to 9, characterised in that said powder mixture is sintered into a form of a sintered body which is used as the target.

11. Process according to one of the claims 1 to 10, characterised in that said powder mixture is sintered in a powder hot-press or in a hot isostatic press (HIP).

12. Process according to one of the claims 1 to 11, characterised in that said sputtering is operated under the presence of oxygen gas.

13. Process according to claim 12, characterised in that the partial pressure of oxygen gas is adjusted to a range comprised between 1,33.10⁻⁴ and 6,67 Pa (10⁻⁶ and 5x10⁻² Torr).

14. Process according to one of the claims 1 to 13, characterised in that a voltage of 10 to 500 V is impressed onto said substrate during the sputtering.

15. Superconducting thin film presenting a composition corresponding to the formula (La₁₋ₓ, Mₓ)₂CuO_{4-y}, where 0 < x < 1, 0 ≦ y < 4, and M is Ba or Sr, obtained with the process according to any one of the claims 1 to 14.

## Patentansprüche

1. Verfahren zum Herstellen einer supraleitenden dünnen Schicht, die aus einer Oxydverbindung aus La und Cu und Sr besteht, mittels der Technik der Kathodenzerstäubung, dadurch gekennzeichnet, daß es die Verwendung eines Targets aufweist, das aus einem Pulvergemisch aus Oxyden, Carbonaten, Nitraten und/oder Sulfaten des La, Cu und Sr besteht, und daß das Substrat, auf dem der dünne Film abgeschieden wird, während der Kathodenzerstäubung auf eine Temperatur zwischen 200 und 1200°C erwärmt wird.

2. Verfahren zum Herstellen einer supraleitenden dünnen Schicht, die aus einer Oxydverbindung aus La und Cu und Ba besteht, mittels der Technik der Kathodenzerstäubung, dadurch gekennzeichnet, daß es die Verwendung eines Targets aufweist, das aus einem Pulvergemisch aus Oxyden, Carbonaten, Nitraten und/oder Sulfaten des La, Cu und Ba besteht, und daß das Substrat, auf dem der dünne Film abgeschieden wird, während der Kathodenzerstäubung auf eine Temperatur zwischen 200 und 1200°C erwärmt wird.

3. Verfahren nach Anspruch 1 oder 2, dadurch gekennzeichnet, daß die supraleitende dünne Schicht eine Zusammensetzung entsprechend der Formel (La₁₋ₓ, Mₓ)₂CuO_{4-y} aufweist, wobei o < x < 1, 0 ≦ y < 4, und M entweder Ba oder Sr ist.

4. Verfahren nach Anspruch 3, dadurch gekennzeichnet, daß das mit M bezeichnete Element Ba ist und daß der Wert von x in der Zusammensetzung im Bereich zwischen 0,025 und 0,125 gewählt wird.

5. Verfahren nach Anspruch 3, dadurch gekennzeichnet, daß das mit M bezeichnete Element Sr ist und daß der Wert von x in der Zusammensetzung im Bereich von 0,09 bis 0,25 gewählt wird.

6. Verfahren nach einem der Ansprüche 1 bis 5, dadurch gekennzeichnet, daR die supraleitende dünne Schicht die Kristallstruktur von Oxyden des Typs K₂NiF₄ einschließt.

7. Verfahren nach einem der Ansprüche 1 bis 6, dadurch gekennzeichnet, daR das Pulvergemisch aus La₂CO₃ und CuO und entweder BaCO₃ oder SrCO₃ besteht.

8. Verfahren nach einem der Ansprüche 1 bis 7, dadurch gekennzeichnet, daß das Pulvergemisch aus 70 bis 95 Gew.-% La₂CO₃, 1 bis 20 Gew.-% BaCO₃ oder SrCO₃ und 1 bis 30 Gew.-% CuO besteht.

9. Verfahren nach einem der Ansprüche 1 bis 8, dadurch gekennzeichnet, daß der abgeschiedene dünne Film nach der Kathodenzerstäubung auf eine Temperatur zwischen 600 und 1200° C erwärmt wird.

10. Verfahren nach einem der Ansprüche 1 bis 9, dadurch gekennzeichnet, daß das Pulvergemisch in die Form eines Sinterkörpers gesintert wird, welcher als Target verwendet wird.

11. Verfahren nach einem der Ansprüche 1 bis 10, dadurch gekennzeichnet, daß das Pulvergemisch in einer Pulver-Heizpresse oder in einer heißen isostatischen Presse (HIP) gesintert wird.

12. Verfahren nach einem der Ansprüche 1 bis 11, dadurch gekennzeichnet, daß die Kathodenzerstäubung bei Anwesenheit von Sauerstoffgas durchgeführt wird.

13. Verfahren nach Anspruch 12, dadurch gekennzeichnet, daß der Partialdruck des Sauerstoffgases derart eingestellt wird, daß er in einem Bereich zwischen 1,33 x 10⁻⁴ und 6,67 Pa (10⁻⁶ und 5 x 10⁻² Torr) liegt.

14. Verfahren nach einem der Ansprüche 1 bis 13, dadurch gekennzeichnet, daß während der Kathodenzerstäubung am Substrat eine Spannung von 10 bis 500 V angelegt wird.

15. Supraleitende dünne Schicht, die eine Zusammensetzung aufweist entsprechend der Formel (La₁₋ₓ, Mₓ)₂CuO_{4-y}, wobei 0 < x < 1, 0 ≦ y < 4 und M entweder Ba oder Sr ist, und die gemäß dem Verfahren nach einem der Ansprüche 1 bis 14 hergestellt worden ist.

## Revendications

1. Un procédé pour la préparation d'une fine pellicule supra-conductrice composée d'un oxyde de La, Cu et Sr par une technique de pulvérisation cathodique caractérisé en ce qu'il comprend l'utilisation d'une cible composée d'un mélange pulvérulent d'oxydes, carbonates, nitrates et/ou sulfates de La, Cu et Sr et en ce que le substrat sur lequel la fine pellicule est déposée, est chauffé à une température comprise entre 200°C et 1 200°C durant la pulvérisation cathodique.

2. Un procédé pour la préparation d'une fine pellicule supra-conductrice composée d'un oxyde de La, Cu et Ba par une technique de pulvérisation cathodique caractérisé en ce qu'il comprend l'utilisation d'une cible composée d'un mélange pulvérulent d'oxydes, carbonates, nitrates et/ou sulfates de La, Cu et Ba et en ce que le substrat sur lequel la fine pellicule est déposée, est chauffé à une température comprise entre 900°C et 1 200°C durant la pulvérisation cathodique.

3. Le procédé selon la revendication 1 ou 2, caractérisé en ce que la fine pellicule supra-conductrice présente une composition correspondant à la formule (La₁₋ₓ,Mₓ)₂CuO_{4-y}, dans laquelle 0 < x < 1, 0 ≦ y < 4 et M représente Ba ou Sr.

4. Le procédé selon la revendication 3, caractérisé en ce que ledit élément M représente Ba et en ce que la valeur de x dans la composition est sélectionnée entre 0,025 et 0,125.

5. Le procédé selon la revendication 3, caractérisé en ce que ledit élément M représente Sr et en ce que la valeur de x dans la composition est sélectionnée entre 0,09 et 0,25.

6. Le procédé selon l'une quelconque des revendications 1 à 5, caractérisé en ce que ladite fine pellicule supraconductrice comprend, sous une forme cristalline des oxydes de type K₂NiF₄.

7. Le procédé selon l'une quelconque des revendications 1 à 6, caractérisé en ce que ledit mélange pulvérulent est composé de La₂CO₃ et CuO et de l'un des oxydes BaCO₃ ou SrCO₃.

8. Le procédé selon l'une quelconque des revendications 1 à 7, caractérisé en ce que ledit mélange pulvérulent est composé de 70 à 95% en poids de La₂CO₃, de 1 à 20% en poids de BaCO₃ ou SrCO₃ et de 1 à 30% en poids de CuO.

9. Le procédé selon l'une quelconque des revendications 1 à 8, caractérisé en ce que la fine pellicule déposée est soumise à un traitement thermique à une température comprise entre 600 et 1 200°C après l'étape de pulvérisation cathodique.

10. Le procédé selon l'une quelconque des revendications 1 à 9, caractérisé en ce que ledit mélange pulvérulent est fritté en un corps fritté qui est utilisé comme cible.

11. Le procédé selon l'une quelconque des revendications 1 à 10, caractérisé en ce que ledit mélange pulvérulent est fritté dans une presse de poudre à chaud ou dans une presse isostatique à chaud (HIP).

12. Le procédé selon l'une quelconque des revendications 1 à 11, caractérisé en ce que ladite pulvérisation cathodique est mise en présence de gaz d'oxygène.

13. Le procédé selon la revendication 12, caractérisé en ce que la pression partielle en oxygène gazeux est ajustée à une valeur comprise entre 1,33.10⁻⁴ et 6,67 Pa (10⁻⁶ et 5 x10⁻² Torr).

14. Le procédé selon l'une quelconque des revendications 1 à 13, caractérisé en ce qu'un voltage compris entre 10 et 500 V est appliqué sur ledit substrat durant la pulvérisation cathodique.

15. Une fine pellicule supra-conductrice présentant une composition correspondant à la formule (La₁₋ₓ,Mₓ)₂CuO_{4-y}, dans laquelle 0 < x < 1, 0 ≦ y < 4 et M représente Ba ou Sr obtenue par le procédé selon l'une quelconque des revendications 1 à 14.
